Europäisches Patentamt

(19) European Patent Office

Office européen des brevets

(11) Publication number: **0 160 941**
**A2**

(12) # EUROPEAN PATENT APPLICATION

(21) Application number: **85105376.9**

(22) Date of filing: **02.05.85**

(51) Int. Cl.⁴: **H 01 L 23/52**
**H 01 L 23/56**

(30) Priority: **07.05.84 US 607549**

(43) Date of publication of application:
**13.11.85 Bulletin 85/46**

(84) Designated Contracting States:
**DE FR NL**

(71) Applicant: **GENERAL ELECTRIC COMPANY**
**1 River Road**
**Schenectady New York 12305(US)**

(72) Inventor: **Love, Robert Paul**
**49 Hillcrest Avenue**
**Schenectady New York 12304(US)**

(74) Representative: **Catherine, Alain**
**General Electric - Deutschland Munich Patent Operations**
**Frauenstrasse 32**
**D-8000 München 5(DE)**

(54) High voltage interconnect system for a semiconductor integrated circuit.

(57) High voltage interconnects in an integrated circuit are spaced from one or more selected regions of a semiconductor wafer by a field-shield layer comprising a layer of polycrystalline, oxygen-doped silicon on the wafer surface and an insulating layer overlying the polycrystalline silicon layer. The high voltage interconnects can operate, for example, at a voltage of 600 volts above the potential of the selected regions of the wafer without adverse effect on integrated circuit operation. In one form, the selected region of the wafer comprises a highly-doped, voltage-referenced region within the semiconductor wafer and, in another form, comprises a lateral field-supporting region within the wafer.

EP 0 160 941 A2

./...

Croydon Printing Company Ltd

FIG.1

BIPOLAR TRANSISTOR 12

HIGH VOLTAGE
BASE INTERCONNECT 15

HIGH VOLTAGE EMITTER
INTERCONNECT 17
EMITTER 40 30b

HIGH VOLTAGE
COLLECTOR INTERCONNECT 15

P⁺ SUBSTRATE 16

N⁺ HIGH VOLTAGE TUB 36

P⁺ VOLTAGE-
REFERENCED
REGION 44

N⁺ LATERAL
FIELD-
SUPPORTING
REGION 42

N⁺ VOLTAGE-
REFERENCED
REGION 40

# HIGH VOLTAGE INTERCONNECT SYSTEM FOR A
# SEMICONDUCTOR INTEGRATED CIRCUIT

## Background of the Invention

The present invention relates to high voltage interconnects (i.e., electrodes) utilized in a semiconductor integrated circuit for electrically interconnecting different devices in the integrated circuit. The invention more particularly relates to a high voltage interconnect system wherein high voltage interconnects are situated in close proximity to either highly-doped voltage-referenced regions or to lateral field-supporting regions.

Semiconductor integrated circuits frequently include highly-doped voltage-referenced regions, that is, highly-doped semiconductor regions referenced to a known potential in the integrated circuit, as opposed to being unreferenced, or free floating, in potential. By "highly-doped" is meant herein at least $10^{17}$, and, preferably, more than $10^{20}$, dopant atoms per cubic centimeter. A problem resides in the prior art where it is desired to lay a high voltage interconnect over a voltage-referenced region, "high voltage" as used herein constituting a voltage in excess of about 50 volts. The problem is that, unless adequate dielectric separation is provided between the voltage-referenced region and the high voltage interconnect, an extremely high electric field gradient may be created in the voltage-referenced region and causes device failure due to avalanche breakdown. An approach used in the prior art to assure adequate dielectric separation is to space the interconnect from the voltage-referenced region by a relatively thick, typically, 10 micron,

1

insulation layer of silicon dioxide or silicon nitride. Such layers, however, are about 10 times thicker than other insulation layers typically provided on the integrated circuit device. The interconnect, having a portion connected to the semiconductor surface, must scale the height of the thick insulation. It is difficult to assure that the vertical portions of the interconnect which scale the thick insulation are formed intact. Accordingly, device fabrication cost is increased since yields of operative devices are lowered.

Integrated circuits frequently also include lateral field-supporting regions. These regions are used, for example, between a semiconductor device included in an integrated circuit and operated at high voltage and a grounded isolation region that surrounds the semiconductor device to isolate the semiconductor device from other devices contained in the integrated circuit. The influence of a high electric field, radiating from a high voltage interconnect and impinging upon the lateral field-supporting region can reduce the voltage that can be supported by the region. A prior art approach to preventing a high electric field from impinging on the field-supporting region is to dielectrically separate the overlying interconnect from the lateral field-supporting region by a thick insulator, such as a 10-micron layer of silicon dioxide or silicon nitride. Here, again, the problem of assuring that the portions of the interconnect which scale the sides of the thick insulation layers are formed intact results in increased device fabrication cost due to reduced device yields.

2

The deleterious interference of high electric fields, radiating from a high voltage interconnect, upon a lateral field-supporting region is particularly acute where the voltage-supporting region has been designed in accordance with a technology known as reduced surface field (RESURF) technology. This is because such RESURF-designed lateral field-supporting region has its geometry and doping concentration very precisely controlled in order to achieve maximum device breakdown voltage ratings while minimizing the area of a semiconductor chip occupied by the lateral field-supporting region. In particular, the product of the doping concentration and thickness of a lateral field-supporting region is typically in the range of about $0.2 \times 10^{12}$ atoms/cm$^2$ to $1.4 \times 10^{12}$ atoms/cm$^2$. Particular details of RESURF technology may be found in the literature; for example, in an article by JA Appels et al., "High Voltage Thin Layer Devices (RESURF) Devices", Proceedings of the 1979 IEEE International Electron Device Meeting, pages 238-241.

From the foregoing, it will be appreciated that an approach to dielectrically separating high voltage interconnects from either voltage-referenced regions or lateral field-supporting regions thereunder, which does not involve relatively thick insulating layers, would be desirable.

## Summary of the Invention

Accordingly, it is an object of the present invention to provide a high voltage interconnect system for an integrated circuit in which the interconnects scale minimum heights.

3

A further object of the invention is to provide a high voltage interconnect system for an integrated circuit that can be readily incorporated into existing high voltage integrated circuit fabrication processes.

It is a more particular object of the present invention to provide a high voltage interconnect system for an integrated circuit wherein high voltage interconnects can operate at voltages in excess of 600 volts without deleterious effects on either voltage-referenced regions or lateral field-supporting regions underlying the interconnects.

In accordance with a preferred embodiment of the invention, a high voltage interconnect system for an integrated circuit includes a semiconductor wafer having field-shield layers thereon. Each field-shield layer comprises a polycrystalline, oxygen-doped, silicon layer overlying a select region of the wafer and an insulating layer, such as silicon dioxide, overlying the polycrystalline, oxygen-doped, silicon layer. An interconnect electrode overlies the insulating layer and is adapted to operate at a potential difference of about 50 volts from that of the select region of the semiconductor wafer.

In one embodiment of the invention, the select region of the semiconductor wafer overlain by the interconnect comprises a voltage-referenced region doped in excess of about $10^{20}$ dopant atoms per cubic centimeter. In another embodiment of the invention, the select region of the semiconductor wafer comprises a lateral field-supporting region.

With the interconnect overlying a voltage-referenced region and being operated at 600 volts

4

above the potential of such region, the combined thickness of the polycrystalline, oxygen-doped silicon layer and the insulating layer overlying such polycrystalline layer can be below about 1.3 microns, with attainment of successful shielding of the voltage-referenced region from high electric fields.

### Brief Description of the Drawings

The features of the invention deemed to be novel are defined in the appended claims. The invention itself, however, both as to organization and method of operation, together with further objects and advantages thereof, may be best understood with reference to the following description when read in conjunction with the accompanying drawings, in which:

Figure 1 is a cross-sectional view of an integrated circuit incorporating features of the present invention;

Figure 2 is an enlarged detail view of a preferred modification of an insulating layer of the Figure 1 device; and

Figure 3 is a graphical depiction of a frequency-dependent aspect of the present invention.

### Detailed Description of the Preferred Embodiments

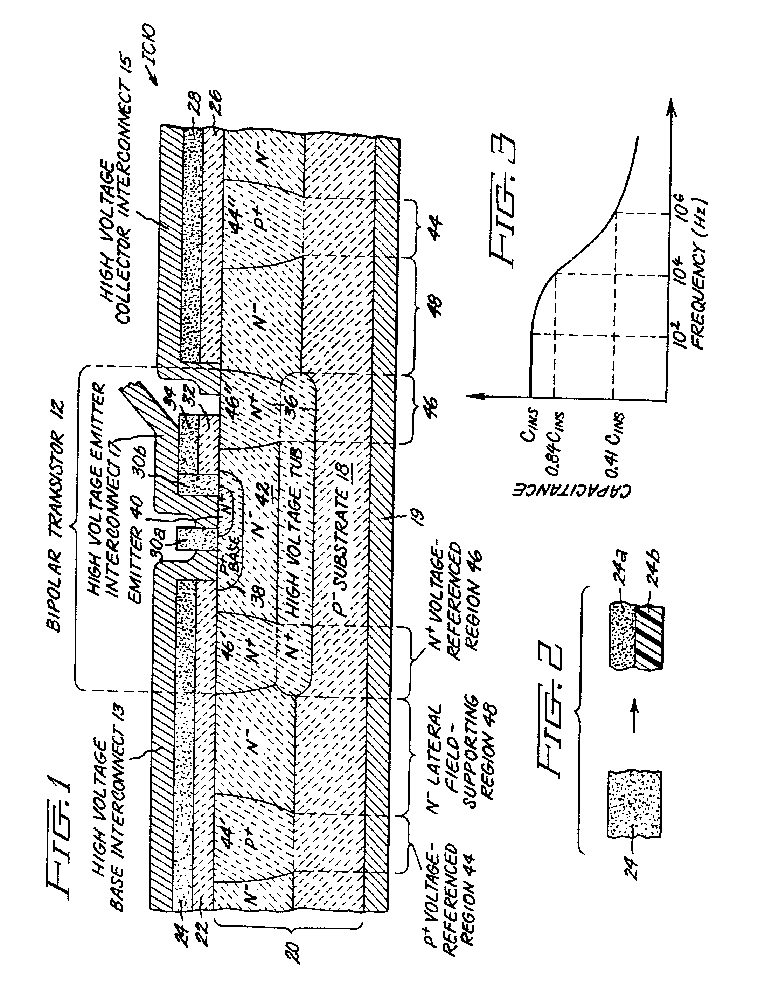

With reference to the drawings, Figure 1 illustrates an integrated circuit (IC), generally designated 10, incorporating features of the present invention. IC 10 includes a semiconductor wafer 20 containing an NPN bipolar transistor 12 in which current flow is vertical. Transistor 12, made up of base region 38, emitter region 40 and collector regions 36 and 42, includes a high voltage base interconnect 13

5

and a high voltage collector interconnect 15. Transistor 12 additionally includes an emitter electrode 17.

IC 10 further includes a P⁻ (or high resistivity, P-conductivity type) substrate 18, which constitutes a common substrate for all integrated devices in IC 10, such as transistor 12. An electrode 19 adjoins P⁻ substrate 18 and is typically biased to a ground or reference potential.

High voltage base interconnect 13 is spaced from semiconductor wafer 20 by field-shield layers 22 and 24. Layer 22 comprises a polycrystalline silicon layer that is doped with oxygen to an average of preferably between 2 and 45 atomic percent, this material being known in the art as Semi-Insulating Polycrystalline Oxygen Doped Silicon (SIPOS). Briefly, oxygen doping of polysilicon can be accomplished by using low pressure, chemical vapor deposition technique to react silane and nitrous oxide at approximately 620°C to form polycrystalline silicon layer 22. Further details of preparation of suitable polycrystalline, oxygen-doped silicon can be found, for example, in "High Reliability High Voltage Transistors by Use of the SIPOS Process", IEEE Transactions on Electron Devices, Vol. 23, No. 8, (August 1976), pages 8260-830. Layer 24 comprises an insulating material such as silicon dioxide overlying first layer 22. Similarly, high voltage collector interconnect 15 is spaced from semiconductor wafer 20 by field-shield layers 26 and 28, which suitably are essentially similar to layers 22 and 24, respectively, beneath interconnect 13. Emitter interconnect 17 is spaced from a portion of transistor base region 38 via insulating layers 30a and 30b of silicon dioxide, for example, which also passivate the portions of wafer 20 covered by layers 30a and 30b. Emitter interconnect 17 is also spaced from the high voltage collector regions 36 and 42 by field-shield layers 32 and 34, which preferably overlap at least a small portion of transistor base region 38 to conveniently assure coverage of collector regions 36 and 42. Field-shield layers 32 and 34 suitably are essentially similar to field-shield layers 22 and 24, respectively, beneath interconnect 13.

IC 10 includes an $N^+$ high voltage tub 36, which forms a closed region around $N^-$ region 42 and which may be round or square as viewed from above, by way of example. $N^+$ tub 36 contains the following semiconductor regions of NPN bipolar transistor 12: $P^+$ base region 38, $N^+$ emitter region 40, and $N^-$ collector region 42 (the superscripts "+" and "-" signifying low and high resistivity regions, respectively). $N^+$ high voltage tub 36 is highly doped so as to provide a low resistance interconnection between $N^-$ collector region 42 and high voltage collector interconnect 15. Further details of transistor 12 can be found by referring to copending, commonly-assigned application Serial No. 558,405, filed on 5 December 1983 and entitled SEMICONDUCTOR WAFER WITH AN ELECTRICALLY-ISOLATED SEMICONDUCTOR DEVICE, by EJ Wildi and TP Chow.

IC 10 includes voltage-referenced regions 44 and 46. Region 44 is highly doped to P conductivity type and adjoins $P^-$ substrate 18 so as to be referenced to the potential of substrate 18, which is typically at a ground or reference level. Region 44 forms a continuous link around bipolar transistor 12, as viewed from above, so as to electrically isolate transistor 12 from

7

other devices in IC 10 outside the link. In this regard, portions of voltage-referenced region 44 appear on both the right and left sides of IC 10 in Figure 1. The further voltage-referenced region 46 comprises the upper portion of $N^+$ high voltage tub 36, which is highly doped. One further region of immediate interest in IC 10 is $N^-$ lateral field-supporting region 48, which supports a lateral voltage drop between $N^+$ high voltage tub 36 and $P^+$ voltage-referenced region 44.

The various field-shield layers of the present invention, that is, layers 22 and 24, layers 26 and 28, and layers 32 and 34, shield the portions of wafer 20 respectively overlain by such layers from high electric fields radiating from high voltage interconnects 13, 15, and 17, respectively. With reference to base interconnect 13, such interconnect can be operated at high voltage with respect to the left-hand portions 44' and 46' of voltage-referenced regions 44 and 46, respectively, without deleterious effects to portions 44' and 46'.

More particularly, base interconnect 13 can operate without danger to IC 10 at fairly high voltages, such as 600 volts, with polycrystalline silicon layer 22 and insulating layer 24 being, in the aggregate, only about 1.3 microns thick. Specifically, this occurs with polycrystalline silicon layer 22 being approximately 0.5 microns in thickness and being doped with 28 percent oxygen and insulating layer 24 comprising silicon dioxide of 8,000 Angstroms thickness.

Field-shield layers 22 and 24 additionally protect the left-hand portion of $N^-$ lateral field-supporting region 48 from the high electric field on high voltage base interconnect 13. Specifically,

8

high voltage base interconnect 13 can be operated at 600 volts, by way of example, without interfering with a depletion phenomenon, responsible for a high breakdown voltage rating, that occurs in $N^-$ lateral field-supporting region 48 while supporting the high lateral voltage between $N^+$ high voltage tub 36 and the left-hand portion of $P^+$ voltage-referenced region 44. This can be accomplished with polycrystalline silicon layer 22 and insulating layer 24 conforming to the above specifications.

With reference to high voltage collector interconnect 15, such interconnect can be operated at 600 volts, for example, with respect to the right-hand portion 44" of voltage-referenced region 44, without adversely affecting voltage-referenced portion 44". This is accomplished with field-shield layer 26 comprising polycrystalline silicon of approximately 0.5 microns thickness and with a doping level of 28 percent oxygen and field-shield layer 28 comprising silicon dioxide of 8,000 Angstroms thickness.

Field-shield layers 26 and 28 conforming to the foregoing specifications also protect from a high electric field the right-hand portion of $N^-$ lateral field-supporting region 48. With field-shield layers 26 and 28 so constructed, high voltage collector interconnect 15 can be operated at 600 volts, by way of example, with respect to $N^-$ region 48 without mishap to IC 10.

With reference to high voltage emitter electrode 17, such electrode can be operated at 600 volts, for example, with respect to the right-hand, voltage-referenced portion 46" of $N^+$ high voltage tub 36, such portion comprising a collector region of

9

transistor 12, or with respect to $N^-$ collector region 42, without mishap to IC 10.

Figure 2 illustrates in enlarged form a preferred modification of insulating layer 24 of Figure 1. A modified insulating layer 24, as illustrated, comprises sublayers 24a and 24b, with sublayer 24a comprising silicon dioxide and sublayer 24b comprising silicon nitride. Nitride layer 24b, as known in the art, is useful as a sodium and moisture barrier. Further modifications of insulating layer 24 will be within the purview of those skilled in the art. Although not illustrated, insulating layers 28 and 34 of Figure 1 are preferably also modified so as to each comprise sublayers of silicon dioxide and silicon nitride.

In selecting polycrystalline silicon layers and the respective, overlying insulating layers for achieving the purposes of the present invention, the following distinction between direct current (DC) device operation and alternating current (AC) device operation has been determined by the present inventor. For DC device operation, the high voltage interconnects of the present invention can operate at a voltage above that of the overlain semiconductor material as determined by the dielectric strength of just the insulating layers, the dielectric strength of the polycrystalline silicon layers being negligible. This can be explained in the following manner.

Oxygen-doped polycrystalline silicon layers apparently have interspersed therein "traps", or sites, that can take in mobile carriers from the underlying semiconductor wafer. Under DC device operation, mobile carriers from the semiconductor wafer can migrate to the uppermost portion of a polycrystalline silicon layer and there simulate an electrode of a capacitance (not illustrated). The dielectric medium of the capacitance comprises the respective, overlying insulating layer, with high voltage interconnect comprising the other electrode of the capacitance.

Under AC device operation, mobile carriers from the semiconductor wafer migrate only partially upward through a polycrystalline silicon layer and simulate an electrode at the level they reach. With the high voltage interconnect comprising the other electrode of the capacitance, the dielectric medium thereof comprises the respective, overlying insulating layer together with the portion of the polycrystalline silicon layer above the simulated electrode therein. As a result, the capacitance formed in the AC case is lower than in the DC case, since the thickness of the dielectric medium is greater. The phenomenon is graphically depicted in Figure 3, wherein $C_{INS}$ represents DC value of capacitance, with the capacitance level of the foregoing-described capacitance falling in value at frequencies greater than about $10^2$ Hz, reaching about 0.84 $C_{INS}$ at $10^4$ Hz and about 0.41 $C_{INS}$ at $10^6$ Hz, for example.

From the foregoing, it will be appreciated that, for AC device operation, the thickness of the insulating layer overlying a polycrystalline silicon layer in accordance with the invention can be reduced from that required for DC device operation.

From the foregoing it will be appreciated that the present invention provides a high voltage (e.g., 600 volt) interconnect system in which the interconnects are reliably formed since they scale

11

0160941

minimum heights.  The interconnect system is readily incorporated into existing integrated circuit fabrication processes and permits integration and interconnection of a variety of semiconductor devices.

While only certain preferred features of the invention have been shown by way of illustration, many modifications and changes will occur to those skilled in the art.  It is, therefore, to be understood that the appended claims are intended to cover all such modifications and changes as fall within the true spirit and scope of the invention.

What is claimed is:

1. A high voltage interconnect system for an integrated circuit, comprising:

(a) a semiconductor wafer including a substrate layer and a voltage-referenced region overlying said substrate layer and doped to at least about $10^{17}$ dopant atoms per cubic centimeter;

(b) a polycrystalline, oxygen-doped silicon layer overlying said voltage-referenced region;

(c) an insulating layer disposed on said polycrystalline, oxygen-doped silicon layer; and

(d) a high voltage interconnect electrode disposed on said insulating layer and being situated above said voltage-referenced region.

2. A high voltage interconnect system in accordance with claim 1, wherein said voltage-referenced region comprises an isolation region adjoining said substrate of said semiconductor wafer.

3. A high voltage interconnect system in accordance with claim 1, wherein said voltage-referenced region is doped more heavily than about $10^{20}$ dopant atoms per cubic centimeter.

4. A high voltage interconnect system for an integrated circuit, comprising:

(a) a semiconductor wafer including a lateral field-supporting region;

(b) a polycrystalline, oxygen-doped silicon layer disposed on said lateral field-supporting region;

(c) an insulating layer disposed on said polycrystalline, oxygen-doped silicon layer; and

(d) a high voltage interconnect electrode overlying said insulating layer.

13

5. A high voltage interconnect system in accordance with claim 4, wherein the doping concentration of said lateral field-supporting region is below about $10^{15}$ dopant atoms per cubic centimeter.

6. A high voltage interconnect system in accordance with claim 4 wherein the product of doping concentration and thickness of said lateral field-supporting region is in the range of about 0.2 x $10^{12}$ atoms per cm² to 1.4 x $10^{12}$ atoms per cm².

FIG.1

BIPOLAR TRANSISTOR 12

HIGH VOLTAGE
BASE INTERCONNECT 13

HIGH VOLTAGE EMITTER
INTERCONNECT 17

EMITTER 40    30b

HIGH VOLTAGE
COLLECTOR INTERCONNECT 15

IC10

P⁺ VOLTAGE-
REFERENCED
REGION 44

N⁻ LATERAL
FIELD -
SUPPORTING
REGION 48

N⁺ VOLTAGE-
REFERENCED
REGION 46

46    48    44

FIG.2

FIG.3

1 / 1

C160941